# EUROPEAN PATENT APPLICATION

(11) **EP 4 836 642 A1**
(43) Date of publication of application: **04.11.2026**
(21) Application number: 25217250.7
(22) Date of filing: 20.11.2025
(51) Int. Cl.: H10F 77/20

(54) **BACK-CONTACT CELL AND FABRICATION METHOD THEREFOR, AND PHOTOVOLTAIC MODULE**

(30) Priority: 28.04.2025 CN 202510551699
(71) Applicant: Jinko Solar (Haining) Co., Ltd., Haining City, Zhejiang (CN)
(72) Inventor: XIA, Zhipeng, Haining (CN); HUANG, Jide, Haining (CN); LIU, Changming, Haining (CN); ZHANG, Xinyu, Haining (CN)
(74) Representative: Balder IP Law, S.L.

(57) **Abstract**

A back-contact cell includes: a cell base, a first doped region and a second doped region on the cell base and spaced apart from each other; a passivation layer disposed on a side of the first /second doped region away from the cell base, a first busbar and a second busbar alternately arranged in a first direction, and a first finger and a second finger alternately arranged in a second direction, at least a portion of a busbar include a non-contact portion and at least one contact portion in contact with the non-contact portion, the contact portion extends through the passivation layer and is in contact with a doped region, and a contact portion is at least located in a gap between two adjacent same-polarity fingers, the busbar is the first/second busbar, the doped region is the first/second doped region, and the same-polarity finger is the first/second finger.

## Description

### TECHNICAL FIELD

The various embodiments described in this document relate in general to the photovoltaic field, and more specifically to a back-contact cell and a fabrication method therefor, and a photovoltaic module.

### BACKGROUND

With the gradual depletion of fossil energy resources, photovoltaic cells have become increasingly popular as a new alternative energy source. A photovoltaic cell is a device that converts solar energy into electrical energy. The photovoltaic cell generates charge carriers through the photovoltaic effect and then uses electrodes to extract the charge carriers, thereby enabling the effective utilization of the generated electrical energy. In order to further reduce the shading of a front surface of the photovoltaic cell caused by grid lines, research on interdigitated back contact (IBC) solar cells has intensified.

However, in addition to shading losses, other factors affecting the photovoltaic conversion efficiency of IBC cells also include optical losses, such as charge carrier recombination losses in a substrate, charge carrier recombination losses in highly doped film layers, and refraction losses of the film layers. Moreover, electrical losses such as resistive losses in the materials, contact losses at the electrodes, contact losses between interconnect ribbons and photovoltaic cells, and poor soldering between interconnect ribbons and IBC cells also affect the photovoltaic conversion efficiency of IBC cells.

Therefore, further research needs to be conducted to improve the photovoltaic conversion efficiency of IBC cells.

### SUMMARY

The embodiments of the present disclosure provide a back-contact cell and a fabrication method therefor, and a photovoltaic module, which are at least conducive to improving the photovoltaic conversion efficiency of the back-contact cell.

In one aspect, some embodiments of the present disclosure provide a back-contact cell, including: a cell base, a doped layer, a passivation layer, first fingers, and at least one first busbar. The doped layer is formed on or in the cell base. The passivation layer is formed on a side of the doped layer away from the cell base. The first fingers are formed over the doped layer, extending in a first direction and arranged at intervals in a second direction intersecting the first direction. The first fingers are penetrating the passivation layer to be electrically connected with the doped layer. The at least one first busbar is formed over the doped layer, extending in the second direction, and electrically connected to the first fingers. A respective busbar of the at least one first busbar includes a plurality of contact portions and a non-contact portion. The plurality of contact portions are arranged at intervals in the second direction, and extend through the passivation layer to be in direct contact with the doped layer, and the non-contact portion extends continuously in the second direction, is located on a side of the plurality of contact portions away from the cell base, and is in direct contact with the plurality of contact portions and the first fingers.

In some embodiments, a respective contact portion of the plurality of contact portions is located between two adjacent first fingers in the second direction.

In some embodiments, the plurality of contact portions and the first fingers satisfy at least one of the following connection relationship: in direct contact with one of the first fingers, in direct contact with two of the first fingers, and in direct contact with three of the first fingers.

In some embodiments, a first portion of the plurality of contact portions is located between two adjacent first fingers in the second direction, and a second portion of the plurality of contact portions and the first fingers satisfy at least one of the following connection relationship: in direct contact with one of the first fingers, in direct contact with two of the first fingers, and in direct contact with three of the first fingers.

In some embodiments, a respective contact portion of the plurality of contact portions includes a plurality of sub-contact portions. The plurality of sub-contact portions are arranged at intervals along the second direction; and a respective sub-contact portion of the sub-contact portions extends through the passivation layer to be electrically connected with the doped layer.

In some embodiments, a respective contact portion of the plurality of contact portions includes a plurality of contact points. The plurality of contact points are arranged at intervals along the first direction, or along the second direction, or along both the first direction and the second direction; and a respective contact point of the contact points extends through the passivation layer to be electrically connected with the doped layer.

In some embodiments, an orthographic projection area of the non-contact portion on the cell base is defined as a first area, an orthographic projection area of the plurality of contact portions on the cell base is defined as a second area, and a ratio of the second area to the first area is in a range of 1:5 to 1:2.

In some embodiments, an orthographic projection of a respective contact portion of the plurality of contact portions on the cell base is sawtooth-shaped or wave-shaped.

In some embodiments, in the first direction, the non-contact portion has a first width; a maximum span of the plurality of contact portions is defined as a second width; a ratio of the second width to the first width is in a range of 1:5 to 1:2; a width of the respective contact portion is defined as a third width; and a ratio of the third width to the second width is in a range of 1:5 to 4:5.

In some embodiments, the at least some of the plurality of contact portions protrude from a surface of the passivation layer away from the cell base.

In some embodiments, the plurality of contact portions are made of a burn-through paste that has been fired to burn through portions of the passivation layer to electrically connect with the doped layer; and the non-contact portion includes a non-burn-through paste formed over the passivation layer.

In some embodiments, the plurality of contact portions fill respective through openings in the passivation layer; and the non-contact portion is formed over the passivation layer outside the at least one opening.

In some embodiments, further includes second fingers formed over the doped layer, extending in a first direction and arranged at intervals in a second direction. The second fingers are penetrating the passivation layer to be electrically connected with the doped layer. The at least one second busbar is formed over the doped layer, extending in a second direction intersecting the first direction, and electrically connected to the second fingers. The first fingers are interrupted at a position of a respective busbar of the at least one second busbar, and the second fingers are interrupted at a position of a busbar of the at least one first busbar.

In some embodiments, the cell base has first doped regions and second doped regions arranged alternatingly thereon. The doped layer includes a first doped portion disposed in the first doped regions and a second doped portion disposed in the second doped regions. The first fingers are extending over the first doped regions and in electrical contact with the first doped portion. The second fingers are extending over the second doped regions and in electrical contact with the second doped portion. An orthographic projection of the at least one first busbar on the cell base and orthographic projections of the first fingers on the cell base are located within an orthographic projection of the first doped portion on the cell base; and an orthographic projection of the at least one second busbar on the cell base and orthographic projections of the second fingers on the cell base are located within an orthographic projection of the second doped portion on the cell base.

In some embodiments, the orthographic projection area of the first doped portion on the cell base is greater than a sum of the orthographic projection areas of the respective first busbar and the first fingers on the cell base; and an orthographic projection area of the second doped portion on the cell base is greater than a sum of the orthographic projection areas of the respective second busbar and the second fingers on the cell base.

In another aspect, some embodiments of the present disclosure provide a back-contact cell, including a cell base, a doped layer, a passivation layer, first fingers, and at least one first busbar. The doped layer is formed on or in the cell base. The passivation layer is formed on a side of the doped layer away from the cell base. The first fingers are formed over the doped layer, extending in a first direction and arranged at intervals in a second direction intersecting the first direction. The first fingers are penetrating the passivation layer to be electrically connected with the doped layer. The at least one first busbar is formed over the doped layer, extending in the second direction, and electrically connected to the first fingers. A respective busbar of the at least one first busbar includes one contact portion and a non-contact portion. The one contact portion extends through the passivation layer to be in direct contact with the doped layer, and the non-contact portion extends continuously in the second direction, is located on a side of the one contact portion away from the cell base, and is in direct contact with the one contact portion and the first fingers.

In some embodiments, the one contact portion is located between two adjacent first fingers in the second direction.

In some embodiments, the one contact portion and the first fingers satisfy at least one of the following connection relationship: in direct contact with one of the first fingers, in direct contact with two of the first fingers, and in direct contact with three of the first fingers.

In some embodiments, the first portion of the one contact portion is located between two adjacent first fingers in the second direction, and a second portion of the one contact portion and the first fingers satisfy at least one of the following connection relationship: in direct contact with one of the first fingers, in direct contact with two of the first fingers, and in direct contact with three of the first fingers.

In another aspect, some embodiments of the present disclosure provide a photovoltaic module, including a plurality of cell strings, a respective cell string of the plurality of cell strings is formed by connecting a plurality of cells, a respective cell of the plurality of cells is the back-contact cell according to any of the foregoing embodiments; at least one encapsulant film is configured to cover a surface of the respective cell string; and at least one cover plate is configured to cover a surface of the at least one encapsulant film away from the plurality of cell strings.

### BRIEF DESCRIPTION OF THE DRAWINGS

One or more embodiments are illustrated with reference to the accompanying drawings, and such exemplary description does not constitute a limitation on the embodiments. Unless otherwise stated, the figures in the accompanying drawings do not constitute a scale limitation. In order to more clearly illustrate technical solutions in the embodiments of the present disclosure or in the existing art, a brief description of the accompanying drawings used in the embodiments will be provided below. Obviously, the accompanying drawings in the following description illustrate only some embodiments of the present disclosure, and those of ordinary skill in the art may derive other drawings from these drawings without inventive effort.
FIG. 1 is a schematic diagram of a partial top view of a back-contact cell according to one embodiment of the present disclosure.
FIG. 2 is a schematic diagram of a partial enlarged top view of a back-contact cell according to one embodiment of the present disclosure.
FIG. 3 is another schematic diagram of a partial enlarged top view of a back-contact cell according to one embodiment of the present disclosure.
FIG. 4 is a schematic diagram of a partial sectional view of the back-contact cell shown in FIG. 2 along a first sectional direction AA1.
FIG. 5 is a schematic diagram of a partial sectional view of the back-contact cell shown in FIG. 2 along a second sectional direction BB1.
FIG. 6 is a schematic diagram of a partial sectional view of the back-contact cell shown in FIG. 2 along a third sectional direction CC1.
FIG. 7 is another schematic diagram of a partial enlarged top view of a back-contact cell according to one embodiment of the present disclosure.
FIG. 8 is yet another schematic diagram of a partial enlarged top view of a back-contact cell according to one embodiment of the present disclosure.
FIG. 9 is another schematic diagram of a partial enlarged top view of a back-contact cell according to one embodiment of the present disclosure along a second sectional direction BB1.
FIG. 10 is one schematic diagram of a partial enlarged top view of a busbar in a back-contact cell according to one embodiment of the present disclosure.
FIG. 11 is another schematic diagram of a partial enlarged top view of a busbar in a back-contact cell according to one embodiment of the present disclosure.
FIG. 12 is one schematic diagram of a partial top view of a busbar in a back-contact cell according to one embodiment of the present disclosure.
FIG. 13 is another schematic diagram of a partial top view of a busbar in a back-contact cell according to one embodiment of the present disclosure.
FIG. 14 is yet another schematic diagram of a partial enlarged top view of a back-contact cell according to one embodiment of the present disclosure along a second sectional direction BB1.
FIG. 15 is yet another schematic diagram of a partial top view of a busbar in a back-contact cell according to one embodiment of the present disclosure.
FIG. 16 is a schematic diagram of a partial sectional view after forming a first doped portion, a second doped portion, and a passivation layer in a fabrication method for a back-contact cell according to another embodiment of the present disclosure.
FIG. 17 is a schematic diagram of a partial sectional view illustrating the formation of an opening in the passivation layer according to another embodiment of the fabrication method for the back-contact cell.
FIG. 18 is a partial sectional view of a back contact cell in accordance with some embodiments of the present disclosure.
FIG. 19 is a partial perspective view of a photovoltaic module according to yet another embodiment of the present disclosure.
FIG. 20 is a schematic diagram of a partial sectional view of the photovoltaic module in FIG. 19 in a fourth cross-sectional direction DD1.

### DETAILED DESCRIPTION OF THE EMBODIMENTS

As known from the background, the photovoltaic conversion efficiency of back-contact cells can be effectively improved.

The present disclosure provides a back-contact cell and a fabrication method therefor, and a photovoltaic module. For the back-contact cell, when charge carriers are generated based on the photovoltaic effect, a first finger is configured to collect charge carriers generated in a first doped portion, and a first busbar in contact with the first finger is configured to further gather the charge carriers collected by the first finger; and a second finger is configured to collect charge carriers generated in a second doped portion, and a second busbar in contact with the second finger is configured to further gather the charge carriers collected by the second finger. On this basis, a gap between two adjacent same-polarity fingers, such as between two adjacent first fingers, is further provided with a first doped portion, and a gap between two adjacent second fingers is further provided with a second doped portion. In this way, at least a portion of the busbars is designed to include contact portions in contact with the doped portions and non-contact portions not in contact with the doped portions. Specifically, at least a portion of the contact portions of the first busbars is in contact with the first doped portion located in a gap between two adjacent first fingers, and/or at least a portion of the contact portions of the second busbars is in contact with the second doped portion located in a gap between two adjacent second fingers, such that charge carriers generated in the doped portions located in a gap between two adjacent fingers of opposite polarities can be directly collected by the busbars, thereby shortening a distance of charge carriers transported from the doped portions to the busbars. As a result, transport losses of charge carriers are reduced, and the charge carrier collection efficiency of the first and/or second busbars is improved, which contributes to enhancing the photovoltaic conversion efficiency of the back-contact cell. In addition, in the busbar that include the contact portion, the non-contact portion does not extend through a passivation layer and is only disposed on a side of the passivation layer away from the cell base, such that the non-contact portion is not in contact with the doped portion, and only a portion of the busbars is in contact with the doped portion, this will improve the charge carrier collection efficiency of the busbar while avoiding excessive charge carrier recombination caused by large-area contact between the busbars and the doped portions, so as to maintain low charge carrier recombination losses.

In the description of the embodiments of the present disclosure, the technical terms "first," "second," and the like, are merely used to distinguish one element from another and should not be construed as indicating or implying relative importance, or implying the number, specific sequence, or priority of the technical features being described. In the description of the embodiments of the present disclosure, "plurality" means two or more, unless expressly specified otherwise.

Any reference to "embodiment(s)" herein means that particular features, structures, or characteristics described in combination with the embodiment(s) may be included in at least one embodiment of the present disclosure. A phrase appearing in various places in the specification does not necessarily refer to the same embodiment, nor is an independent or alternative embodiment mutually exclusive with other embodiments. It is explicitly and implicitly understood by those skilled in the art that the embodiments described herein may be combined with other embodiments.

In the description of embodiments of the present disclosure, the term "and/or" represents merely an association relationship describing associated objects, indicating that there may be three types of relationships, for example, A and/or B, which means three possible cases, that is, the existence of A alone, the existence of both A and B, and the existence of B alone. In addition, the character "/" herein generally indicates that the associated objects are in an "or" relationship.

In the description of embodiments of the present disclosure, the term "a plurality of" means two or more (including two). Similarly, the term "a plurality of groups" means two or more groups (including two groups), and the term "a plurality of pieces" means two or more pieces (including two pieces).

In the description of the present disclosure, the terms "center", "longitudinal", "lateral", "length", "width", "thickness", "upper", "lower", "front", "rear", "left", "right", "vertical", "horizontal", "top", "bottom", "inner", "outer", "clockwise", "counterclockwise", "axial", "radial", "circumferential" and other indicated orientations or positional relationships are based on the orientations or positional relationships shown in the accompanying drawings, and are only for the convenience of describing the embodiments of the present disclosure and simplifying the description, rather than indicating or implying that indicated devices or elements must have a particular orientation, be constructed and operate in a particular orientation and are therefore not to be construed as limitations to the embodiments of the present disclosure.

In the description of the embodiments of present disclosure, it should be noted that, unless otherwise explicitly specified and defined, the technical terms "mounting", "connecting" and "connection" should be understood in a broad sense, for example, they may be a fixed connection, a detachable connection, or an integrated connection; may be a mechanical connection, or an electrical connection; and may be a direct connection, or an indirect connection via an intermediate medium, or communication inside two elements. For those of ordinary skill in the art, specific meanings of the above terms in the embodiments of the present disclosure could be understood according to specific circumstances.

In the drawings corresponding to the embodiments of the present disclosure, for better understanding and ease of illustration, thicknesses and sizes of the layers are enlarged. When describing that a component (such as a layer, film, region, or substrate) is referred to as being "on" another component or "on a surface of another component", the component may be directly on the surface of the other component, or a third component may be disposed between the two components. Conversely, when one component is described as being on the surface of another component, or that one component is describe as being formed or disposed on the surface of another component, it indicates that no third component exists between the two components. Furthermore, when a component is referred to as being "substantially formed on" another component, it means that the component is not formed over the entire surface (or front surface) of the other component, nor merely on a portion of an edge thereof.

In the description of the embodiments of the present disclosure, when a certain component is referred to as "including" another component, unless otherwise specified, it does not exclude the presence of other components, and such other components may also be included. Furthermore, when a component such as a layer, film, region, or plate is referred to as being "on" or "located on" another component, it may be "directly on" the other component (that is, disposed on a surface of the other component with no other components in between), or there may be other components interposed between them. Moreover, when a layer, film, region, or plate is "directly on" another component, or when a layer, film, region, or plate is disposed on the surface of another component, it indicates that no other components are present between them.

The terminology used in the description of the various embodiments herein is intended solely to describe specific embodiments and is not intended to be limiting. As used in the description of the various embodiments and in the appended claims, the singular forms are intended to include the plural forms, unless the context clearly dictates otherwise. The component includes, but is not limited to, a layer, a film, a region, or a plate.

The embodiments of the present disclosure will be described in detail below with reference to accompanying drawings. However, those of ordinary skill in the art may understand that in each embodiment of the present disclosure, many technical details have been put forward in order to make readers better understand the present disclosure. Nevertheless, even without these technical details and various changes and modifications based on the embodiments below, technical solutions to be protected according to the embodiments of the present disclosure may be substantially implemented.

In one embodiment of the present disclosure, a solar cell is provided. The solar cell provided by one embodiment of the present disclosure will be described in detail below with reference to the accompanying drawings.

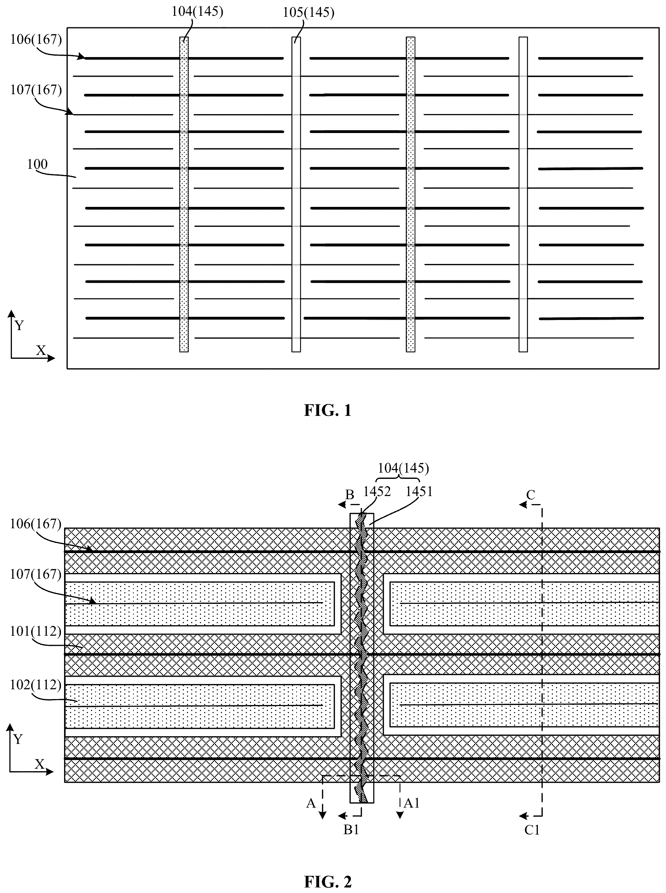

Referring to FIGS. 1-4, the back-contact cell includes a cell base 100, a first doped portion 101 and a second doped portion 102 disposed on or in the cell base 100 and spaced apart from each other, and a passivation layer 103 disposed on a side of both the first doped portion 101 and the second doped portion 102 away from the cell base 100; at least one first busbar104 and at least one second busbar 105 are alternately arranged in a first direction X, and first fingers 106 and second fingers 107 are alternately arranged in a second direction Y; the first fingers 106 are designed to be interrupted at each second busbar 105, and the second fingers 107 are designed to be interrupted at each first busbar 104. Each first busbar 104 is in contact with the first fingers 106, and their orthographic projections on the cell base 100 are located within the orthographic projection of the first doped portion 101 on the cell base 100. Similarly, each second busbar 105 is in contact with the second fingers 107, and their orthographic projections on the cell base 100 are located within an orthographic projection of the second doped portion 102 on the cell base 100. At least a portion of the busbars 145 includes a non-contact portion 1451 and at least one contact portion 1452 in contact with the non-contact portion 1451. The contact portion 1452 extends through the passivation layer 103 and is in contact with a doped layer 112, and a single contact portion 1452 is at least located in a gap between two adjacent same-polarity fingers 167. Specifically, the busbar 145 serves as the first busbar 104, the doped layer 112 serves as the first doped portion 101, and the same-polarity finger 167 serves as the first finger 106, and/or the busbar 145 serves as the second busbar 105, the doped layer 112 serves as the second doped portion 102, and the same-polarity finger 167 serves as the second finger 107.

In other words, the back-contact cell includes a cell base 100, a doped layer112, a passivation layer 103, first fingers 106, and at least one first busbar 104. The doped layer 112 is formed on or in the cell base 100. The passivation layer 103 is formed on a side of the doped layer 112 away from the cell base 100. The first fingers 106 are formed over the doped layer 112. The first fingers 106 extend in a first direction X and are arranged at intervals in a second direction Y that intersects the first direction X. The first fingers 106 penetrate through the passivation layer 103 to be electrically connected with the doped layer 112. At least one first busbar 104 is formed over the doped layer 112. The at least one first busbar 104 extends in the second direction Y and is electrically connected to the first fingers 106; a respective busbar of the at least one first busbar 104 includes a plurality of contact portions 1452 and a non-contact portion 1451; the plurality of contact portions 1452 are arranged at intervals in the second direction Y, and extend through the passivation layer 103 to be in direct contact with the doped layer 112; and the non-contact portion 1451 extends continuously in the second direction Y, is located on a side of the plurality of contact portions 1452 away from the cell base 100, and is in direct contact with the plurality of contact portions 1452 and the first fingers 106.

In other words, the back-contact cell includes a cell base 100, a doped layer112, a passivation layer 103, first fingers 106, and at least one first busbar 104. The doped layer 112 is formed on or in the cell base 100. The passivation layer 103 is formed on a side of the doped layer 112 away from the cell base 100. The first fingers 106 are formed over the doped layer 112. The first fingers 106 extend in a first direction X and are arranged at intervals in a second direction Y that intersects the first direction X. The first fingers 106 pentrate through the passivation layer 103 to be electrically connected with the doped layer 112. At least one first busbar 104 is formed over the doped layer 112. The at least one first busbar 104 extends in the second direction Y and is electrically connected to the first fingers 106; a respective busbar of the at least one first busbar 104 includes one contact portion 1452 and a non-contact portion 1451; the one contact portion 1452 extends through the passivation layer 103 to be in direct contact with the doped layer 112; and the non-contact portion 1451 extends continuously in the second direction Y, is located on a side of the one contact portion 1452 away from the cell base 100, and is in direct contact with the one contact portion 1452 and the first fingers 106.

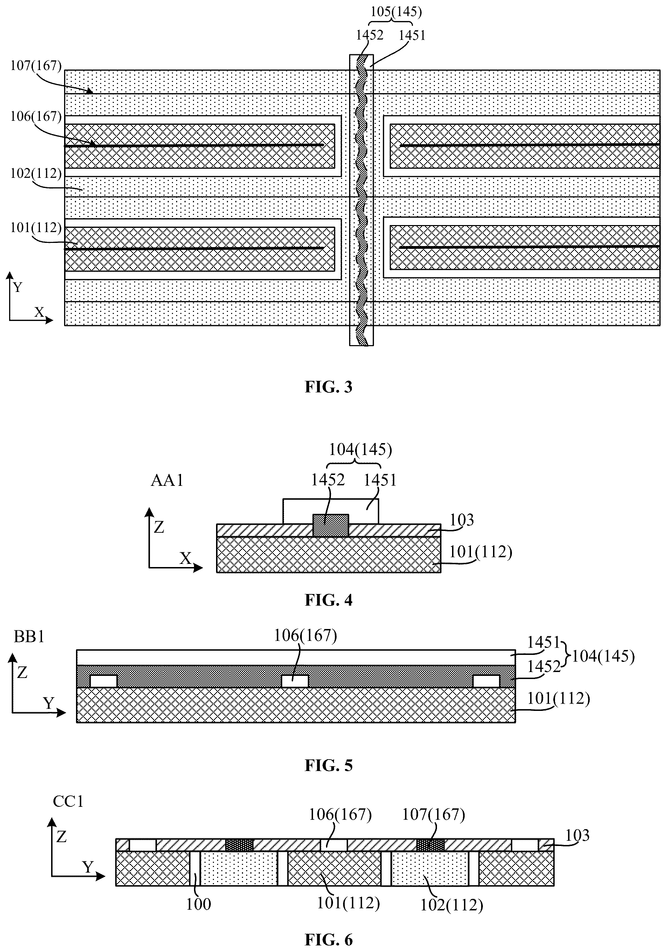

It should be noted that FIG. 1 is a schematic diagram of a partial top view of a back-contact cell according to one embodiment of the present disclosure; FIG. 2 is one schematic diagram of a partial enlarged top view of a back-contact cell according to one embodiment of the present disclosure; FIG. 3 is another schematic diagram of a partial enlarged top view of a back-contact cell according to one embodiment of the present disclosure; and FIG. 4 is a schematic diagram of a partial sectional view of the back-contact cell shown in FIG. 2, taken along a first sectional direction AA1. In FIG. 2, the first busbar 104 is illustrated as an example including the non-contact portion 1451 and at least one contact portion 1452. In FIG. 3, the second busbar 105 is illustrated as an example including the non-contact portion 1451 and at least one contact portion 1452.

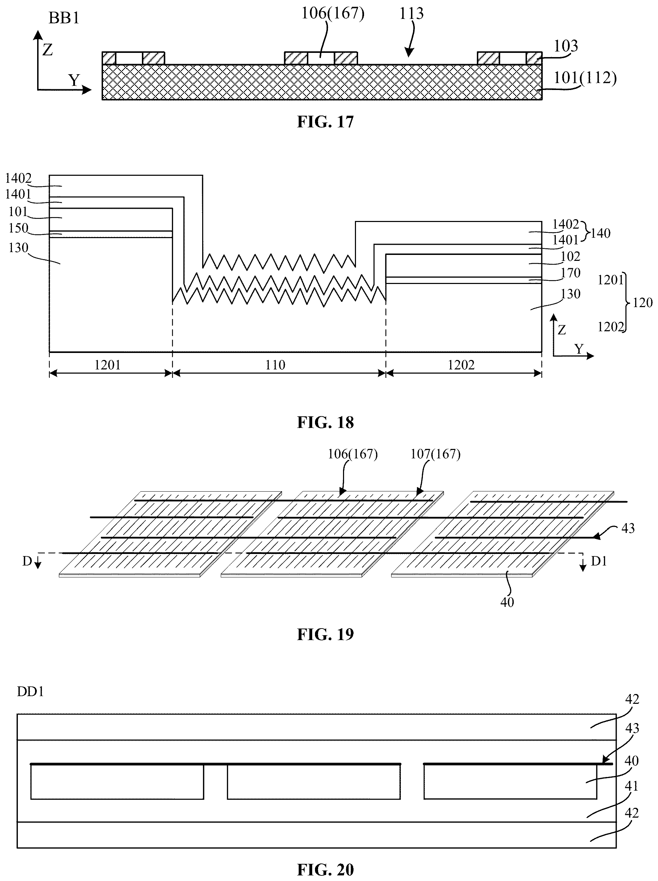

In some cases, with reference to FIG. 18, (FIG. 18 is a partial sectional view of a back contact cell provided in some embodiments of the present disclosure), a portion of the cell base 100 located in the isolation region 110 may include: a substrate 130, and an anti-reflection layer 140 located on a back surface of the substrate 130. A portion of the cell base 100 located in the grid line region 120 may include: the substrate 130, a first tunneling layer 150 and a first doped portion 101 located on the first doped region 1201 and stacked in a third direction Z, a second tunneling layer 170 and a second doped portion 102 located on the second doped region 1202 and stacked in the third direction Z, and the anti-reflection layer 140 located on sides of both the first doped portion 101 and the second doped portion 102 away from the substrate 130. The third direction Z is a thickness direction of the cell base 100.

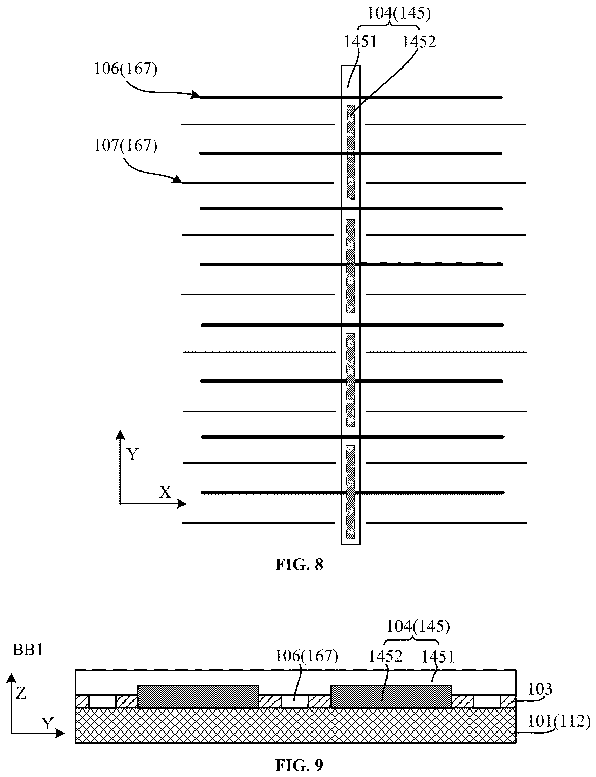

It should be noted that in the portion of the cell base 100 located in the isolation region 110, no other film layers are designed between the substrate 130 and the anti-reflection layer 140, and for example, when no semiconductor layer doped with dopant elements is arranged, a strong electric field is not generated in the portion of the cell base 100 located in the isolation region 110, which is conducive to enhancing an isolation effect of the isolation region 110 on the first doped region 1201 and the second doped region 1202 belonging to different grid line regions 120 respectively. Moreover, with reference to FIG.5 and FIG. 9, the first fingers 106 does not erode the anti-reflection layer 140, and in other words, the first fingers 106 is located on one side of the anti-reflection layer 140 away from the substrate 130 to prevent adverse effects of the first fingers 106 on the photoelectric conversion efficiency of the cell base 100.

Additionally, the first doped portion 101 is doped with one of the P-type dopant element and the N-type dopant element, and the second doped portion 102 is doped with the other of the P-type dopant element and the N-type dopant element; and the first finger 103 is embedded in the anti-reflection layer 140 to achieve contact with the first doped portion 101, and the second finger 104 is embedded in the anti-reflection layer 140 to achieve contact with the second doped portion 102.

In some examples, both the first tunneling layer 150 and the second tunneling layer 170 may be made of silicon oxide, and both the first doped portion 101 and the second doped portion 102 may be made of polycrystalline silicon. In other examples, both the first tunneling layer 150 and the second tunneling layer 170 may be made of intrinsic amorphous silicon, the first doped portion 101 may be made of amorphous silicon doped with one of the P-type dopant element and the N-type dopant element, and the second doped portion 102 may be made of amorphous silicon doped with the other of the P-type dopant element and the N-type dopant element. In yet other examples, one of the first tunneling layer 150 and the second tunneling layer 170 is made of silicon oxide, and the other thereof may be made of intrinsic amorphous silicon; and one of the first doped portion 101 and the second doped portion 102 may be made of polycrystalline silicon doped with one of the P-type dopant element and the N-type dopant element, and the other thereof may be made of amorphous silicon doped with the other of the P-type dopant element and the N-type dopant element.

In some examples, the anti-reflection layer 140 may have a single-layer structure or a stacked structure, and the anti-reflection layer 140 may be made of at least one of aluminum oxide, silicon nitride, silicon oxide, or silicon oxynitride.

In some examples, with further reference to FIG. 18, the anti-reflection layer 140 includes a first anti-reflection layer 1401 and a second anti-reflection layer 1402 stacked in the third direction Z.

In an example, the first anti-reflection layer 1401 may be made of aluminum oxide, and the second anti-reflection layer 1402 may be made of silicon nitride.

In an example, in the third direction Z, a thickness of the first anti-reflection layer 1401 may range from 2 nm to 10 nm, for example, may be 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, or 9.5 nm.

In an example, in the third direction Z, a thickness of the second anti-reflection layer 1402 may range from 40 nm to 200 nm, for example, may be 50 nm, 60 nm, 70 nm, 80 nm, 90 nm, 100 nm, 110 nm, 120 nm, 130 nm, 140 nm, 150 nm, 160 nm, 170 nm, 180 nm, or 190 nm.

In some examples, in the third direction Z, both a thickness of the first tunneling layer 150 and a thickness of the second tunneling layer 170 may range from 1.5 nm to 2.5 nm, for example, may be 1.6 nm, 1.7 nm, 1.8 nm, 1.9 nm, 2 nm, 2.1 nm, 2.2 nm, 2.3 nm, or 2.4 nm; and both a thickness of the first doped portion 101 and a thickness of the second doped portion 102 may range from 50 nm to 300 nm, for example, may be 60 nm, 70 nm, 80 nm, 90 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, or 290 nm.

In addition, first, for the purpose of clearly illustrating positional relationships among the first busbar 104, the second busbar 105, the first fingers 106, and the second fingers 107 on the cell base 100, FIG. 1 does not illustrate the first doped portion 101 and the second doped portion 102 on the cell base 100, nor does it illustrate the specific structures of the busbar 145 and the passivation layer. Furthermore, the first busbar 104 and the second busbar 105 are drawn with different filling patterns, and the first busbar 104 and the second busbar 105 are both presented in a perspective manner, so as to illustrate a connection relationship between the first busbar 104 and the first fingers 106, as well as a connection relationship between the second busbar 105 and the second fingers 107.

Second, for the purpose of clearly illustrating the positional relationships between the first doped portion 101 and the second doped portion 102, and the busbar 145 and the same-polarity finger 167, FIGS. 2 and 3 respectively adopt different filling patterns to depict the first doped portion 101 and the second doped portion 102, and do not illustrate the passivation layer. Third, for the purpose of clearly illustrating a morphology of the contact portion 1452, the busbar 145 is depicted in a white transparent style in both FIGS. 2 and 3. Fourth, in FIGS. 1-3, the first fingers 106 are indicated by thicker solid lines, while the second fingers 107 are indicated by thinner solid lines.

It should be noted that, on the one hand, when the back-contact cell generates charge carriers based on the photovoltaic effect, the first fingers 106 are configured to collect charge carriers generated in the first doped portion 101, and the first busbar 104 in contact with the first fingers 106 is configured to further gather the charge carriers collected by the first fingers 106. On this basis, the first busbar 104 is in contact with the first fingers 106, and their orthographic projections on the cell base 100 are located within the orthographic projection of the first doped portion 101 on the cell base 100. In other words, in a third direction Z, not only is the first finger 106 directly opposite the first doped portion 101, but the first busbar 104 is also directly opposite the first doped portion 101. The third direction Z is a thickness direction of the cell base 100. A gap between two adjacent same-polarity fingers 167, such as between two adjacent first fingers 106, is further provided with one first doped portion 101.

In this way, at least a portion of the first busbars 104 are designed to include the non-contact portion 1451 and the contact portion 1452, where the contact portion 1452 extends through the passivation layer 103 and is in contact with the first doped portion 101, and a single contact portion 1452 is at least located in a gap between two adjacent first fingers 106, the contact portion 1452 of the first busbar 104 is in contact with the first doped portion 101 located in a gap between two adjacent first fingers 106, enabling charge carriers in the first doped portion 101 between the two adjacent first fingers 106 to be directly transported to the non-contact portion 1451 through the contact portion 1452. In other words, charge carriers in the first doped portion 101 between two adjacent first fingers 106 can be directly collected by the first busbar 104 in the third direction Z, without first passing through the first fingers 106 and then being collected by the first busbar 104, thereby shortening a distance of charge carriers transported from the first doped portion 101 to the first busbar 104. As a result, transport losses of charge carriers are reduced, and the charge carrier collection efficiency of the first busbar 104 is improved, which contributes to enhancing the photovoltaic conversion efficiency of the back-contact cell. In addition, in the first busbar 104 that includes the contact portion 1452, the non-contact portion 1451 does not extend through the passivation layer 103 and is only disposed on a side of the passivation layer 103 away from the cell base 100, such that the non-contact portion 1451 is not in contact with the first doped portion 101, and only a portion of the first busbar 104 is in contact with the first doped portion 101, this will improve the charge carrier collection efficiency of the first busbar 104 while avoiding excessive charge carrier recombination caused by large-area contact between the first busbar 104 and the first doped portion 101, so as to maintain low charge carrier recombination losses.

On the other hand, when the back-contact cell generates charge carriers based on the photovoltaic effect, the second fingers 107 are configured to collect charge carriers generated in the second doped portion 102, and the second busbar 105 in contact with the second fingers 107 is configured to further gather the charge carriers collected by the second fingers 107. On this basis, the second busbar 105 is in contact with the second fingers 107, and their orthographic projections on the cell base 100 are located within an orthographic projection of the second doped portion 102 on the cell base 100. In other words, in the third direction Z, not only are the second fingers 107 directly opposite the second doped portion 102, but the second busbar 105 is also directly opposite the second doped portion 102. The third direction Z is a thickness direction of the cell base 100. A gap between two adjacent same-polarity fingers 167, such as between two adjacent second fingers 107, is further provided with one second doped portion 102.

In this way, at least a portion of the second busbars 105 are designed to include the non-contact portion 1451 and the contact portion 1452, where the contact portion 1452 extends through the passivation layer 103 and is in contact with the second doped portion 102, and a single contact portion 1452 is at least located in a gap between two adjacent second fingers 107, the contact portion 1452 of the second busbar 105 is in contact with the second doped portion 102 located in a gap between two adjacent second fingers 107, enabling charge carriers in the second doped portion 102 between the two adjacent second fingers 107 to be directly transported to the non-contact portion 1451 through the contact portion 1452. In other words, charge carriers in the second doped portion 102 between two adjacent second fingers 107 can be directly collected by the second busbar 105 in the third direction Z, without first passing through the second fingers 107 and then being collected by the second busbar 105, thereby shortening a distance of charge carriers transported from the second doped portion 102 to the second busbar 105. As a result, transport losses of charge carriers are reduced, and the charge carrier collection efficiency of the second busbar 105 is improved, which contributes to enhancing the photovoltaic conversion efficiency of the back-contact cell. In addition, in the second busbar 105 that include the contact portion 1452, the non-contact portion 1451 does not extend through the passivation layer 103 and is only disposed on a side of the passivation layer 103 away from the cell base 100, such that the non-contact portion 1451 is not in contact with the second doped portion 102, and only a portion of the second busbar 105 is in contact with the second doped portion 102, this will improve the charge carrier collection efficiency of the second busbar 105 while avoiding excessive charge carrier recombination caused by large-area contact between the second busbar 105 and the second doped portion 102, so as to maintain low charge carrier recombination losses.

In some cases, for the back-contact cell according to one embodiment of the present disclosure, at least a portion of the busbar 145 is designed to include a contact portion 1452 in contact with the doped layer 112, and a non-contact portion 1451 that is not in contact with the doped layer 112. Compared with the configuration in which the entire busbar is disposed on the side of the passivation layer away from the cell base (that is, the entire busbar is not in contact with the doped portion), the configuration of this embodiment is conducive to shortening a distance of charge carriers transported from the doped layer 112 to the busbar 145 by means of the contact portion 1452, thereby reducing transport loss. In addition, the arrangement of the non-contact portion 1451 prevents charge carrier recombination caused by large-area contact between the busbar 145 and the doped layer 112. Therefore, the photovoltaic conversion efficiency of the back-contact cell can be improved by at least approximately 0.05% or more.

The back-contact cell according to one embodiment of the present disclosure will be further described in detail below in conjunction with the accompanying drawings.

In some embodiments, referring to FIGS. 4-6, the first fingers 106 penetrate through the passivation layer 103 and is in contact with the first doped portion 101; similarly, the second fingers 107 penetrate through the passivation layer 103 and is in contact with the second doped portion 102. It is worth noting that most of the surface area of the cell base 100 is formed by the first doped portion 101 and the second doped portion 102. An orthographic projection area of the first doped portion 101 on the cell base 100 is greater than a sum of the orthographic projection areas of the first busbar 104 and the first fingers 106 on the cell base 100, and an orthographic projection area of the second doped portion 102 on the cell base 100 is greater than a sum of the orthographic projection areas of the second busbar 105 and the second fingers 107 on the cell base 100.

FIG. 5 is a schematic diagram of a partial sectional view of the back-contact cell shown in FIG. 2 along a second sectional direction BB1. FIG. 6 is a schematic diagram of a partial sectional view of the back-contact cell shown in FIG. 2 along a third sectional direction CC1.

The busbar 145 that includes a non-contact portion 1451 and at least one contact portion 1452 will be described in detail below. It should be emphasized that the busbar 145 mentioned below may refer to either the first busbar 104 or the second busbar 105.

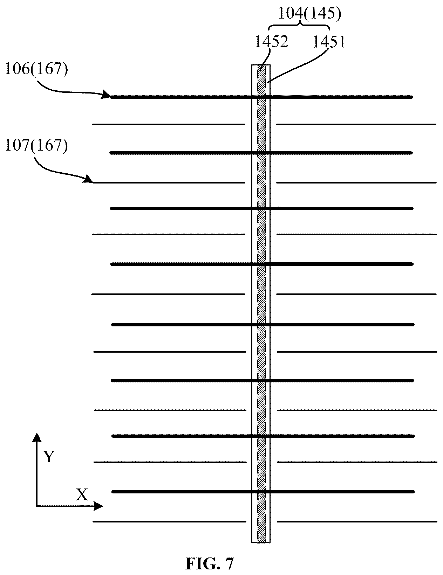

In some embodiments, referring to FIGS. 2 and 5, or referring to FIGS. 2 and 7, where FIG. 7 is yet another schematic diagram of a partial enlarged top view of a back-contact cell according to one embodiment of the present disclosure. A single busbar 145 may include one non-contact portion 1451 and one contact portion 1452. Specifically, the non-contact portion 1451 extends in the second direction Y, and the non-contact portion 1451 directly faces a plurality of same-polarity fingers 167 in the third direction Z.

The positional relationships between the single non-contact portion 1451 and the same-polarity finger 167 include at least the following two examples:

In some examples, referring to FIGS. 2 and 5, or referring to FIGS. 2 and 7, a single contact portion 1452 is in contact with at least one same-polarity finger 167, and is at least located in two gaps among three adjacent same-polarity fingers 167. In this way, charge carriers located near the contact portion 1452 that is in contact with the same-polarity fingers 167 can also be directly transported to the non-contact portion 1451 through the contact portion 1452. Even if the subsequent connection between the interconnect ribbon and the busbar 145 causes breakage at an intersection between the same-polarity finger 167 and the busbar 145, the contact portion 1452 can still effectively collect charge carriers from the doped layer 112 directly opposite the intersection between the same-polarity finger 167 and the busbar 145, thereby ensuring high collection efficiency of charge carriers by the busbar 145.In one example, referring to FIGS. 2 and 7, in the same busbar 145, the contact portion 1452 and the non-contact portion 1451 both extend in the second direction Y, and a single contact portion 1452 is in contact with a plurality of same-polarity fingers 167 in the third direction Z. In this way, a contact portion 1452 is disposed at an intersection between the busbar 145 and any same-polarity finger 167, and a contact portion 1452 is also disposed in the gap between any two adjacent same-polarity fingers 167. This configuration further ensures high charge carrier collection efficiency of the busbar 145 and effectively reduces the risk of breakage at the intersection between the same-polarity finger 167 and the busbar 145.

In other examples, a single contact portion may be located only in a gap between two adjacent same-polarity fingers.

In the two examples described above, in a single busbar 145, one non-contact portion 1451 is in contact with only one contact portion 1452. In the doped layer 112 directly opposite the gap between adjacent same-polarity fingers 167, at least a portion of the region is in contact with the contact portion 1452, such that the charge carriers in the doped layer 112 can be directly collected through the contact portion 1452 without passing through the same-polarity finger 167. This configuration shortens a distance of charge carriers in at least a portion of the doped layer 112 transported to the busbar 145, thereby reducing carrier transport losses and improving carrier collection efficiency of the busbar 145, which ultimately enhances the photovoltaic conversion efficiency of the back-contact cell.

It should be noted that, in FIGS. 2, 4, 5 and 7, the busbar 145 is illustrated only as an example of the first busbar 104. In practical applications, when the second busbar includes both a contact portion and a non-contact portion, the positional relationships between the contact portion and the non-contact portion and the second finger are similar to those between the contact portion and the non-contact portion and the first finger in the first busbar, and thus will not be further described in detail herein.

In other embodiments, referring to FIG. 8 or 9, a single busbar 145 may include one non-contact portion 1451 and a plurality of contact portions 1452 spaced apart. Specifically, the non-contact portion 1451 extends in the second direction Y, and the non-contact portion 1451 directly faces a plurality of same-polarity fingers 167 in the third direction Z.

FIG. 8 is yet another schematic diagram of a partial enlarged top view of a back-contact cell according to one embodiment of the present disclosure; and FIG. 9 is another schematic diagram of a partial enlarged top view of a back-contact cell according to one embodiment of the present disclosure along a second sectional direction BB1.

The positional relationships between the single non-contact portion 1451 and the same-polarity finger 167 include at least the following two examples:

In some examples, referring to FIG. 8, a single contact portion 1452 is in contact with at least one same-polarity finger 167, and is at least located in two gaps among three adjacent same-polarity fingers 167. In this way, charge carriers located near the contact portion 1452 that is in contact with the same-polarity fingers 167 can also be directly transported to the non-contact portion 1451 through the contact portion 1452. Even if the subsequent connection between the interconnect ribbon and the busbar 145 causes breakage at an intersection between the same-polarity finger 167 and the busbar 145, the contact portion 1452 can still effectively collect charge carriers from the doped layer 112 directly opposite the intersection between the same-polarity finger 167 and the busbar 145, thereby ensuring high collection efficiency of charge carriers by the busbar 145.

In one example, still referring to FIG. 8, in the same busbar 145, one same-polarity finger 167 is located between two adjacent contact portions 1452 in the second direction Y. When a single contact portion 1452 is in contact with at least one same-polarity finger 167, charge carriers in the doped layer 112 located between the two adjacent contact portions 1452 in the second direction Y can be preferentially transported through the same-polarity finger 167 or either contact portion 1452, to the non-contact portion 1451, thereby ensuring efficient collection of charge carriers by the busbar 145.

In one example, the plurality of contact portions 1452 and the first fingers 106 satisfy at least one of the following connection relationship: in direct contact with one of the first fingers 106, in direct contact with two of the first fingers 106, and in direct contact with three of the first fingers 106.

In other examples, a first portion of the plurality of contact portions 1452 is located between two adjacent first fingers 106 in the second direction Y, and a second portion of the plurality of contact portions 1452 and the first fingers 106 satisfy at least one of the following connection relationship: in direct contact with one of the first fingers 106, in direct contact with two of the first fingers 106, and in direct contact with three of the first fingers 106.

Referring to FIG. 7, when the busbar 145 includes one contact portion 1452, in one example, the one contact portion 1452 and the first fingers 106 satisfy at least one of the following connection relationship: in direct contact with one of the first fingers 106, in direct contact with two of the first fingers 106, and in direct contact with three of the first fingers 106.

In other examples, the first portion of the one contact portion 1452 is located between two adjacent first fingers 106 in the second direction Y, and a second portion of the one contact portion 1452 and the first fingers 106 satisfy at least one of the following connection relationship: in direct contact with one of the first fingers 106, in direct contact with two of the first fingers 106, and in direct contact with three of the first fingers 106.

In other examples, the one contact portion is located between two adjacent first fingers in the second direction.

In other examples, referring to FIG. 9, a single contact portion 1452 is located only in a gap between two adjacent same-polarity fingers 167.

In one example, still referring to FIG. 9, one contact portion 1452 is disposed in the gap between any two adjacent same-polarity fingers 167. In this way, regions of the doped layer 112 that are located directly opposite the gap between any two adjacent same-polarity fingers 167 are all in contact with the contact portions 1452, enabling the charge carriers in the regions of the doped layer 112 that are farther away from the same-polarity finger 167 can be directly transported to the non-contact portion 1451 through the contact portions 1452, which is conducive to shortening a transport distance of charge carriers in the plurality of regions of the doped layer 112 directly opposite the gap between two adjacent same-polarity fingers 167, thereby further improving the charge carrier collection efficiency of the busbar 145 and enhancing the photovoltaic conversion efficiency of the back-contact cell.

In other words, a respective contact portion 1452 of the plurality of contact portions is located between two adjacent first fingers 106 in the second direction Y.

In the two examples described above, in a single busbar 145, one non-contact portion 1451 is in contact with a plurality of contact portions 1452 spaced apart. This allows the charge carriers from at least at two locations in the doped layer 112 can be transported to the non-contact portion 1451 directly through the contact portions 1452, thereby improving the charge carrier collection efficiency of the busbar 145. In addition, this configuration avoids the presence of a single contact portion 1452 having a large contact area with the doped layer 112 in the busbar 145, thereby further preventing charge carrier recombination caused by large-area contact between the busbar 145 and the doped layer 112, and further reducing recombination loss of charge carriers.

It should be noted that, in FIGS. 8 and 9, the busbar 145 is illustrated only as an example of the first busbar 104. In practical applications, when the second busbar includes both a polarity of contact portions and a non-contact portion, the positional relationships between the contact portion and the non-contact portion and the second fingers are similar to those between the contact portion and the non-contact portion and the first finger in the first busbar embodiments, and thus will not be further described in detail herein.

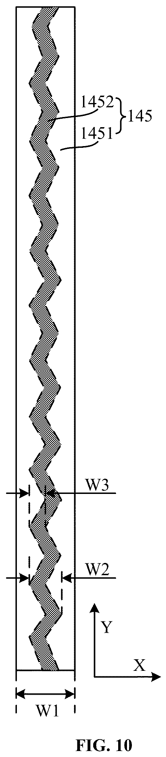

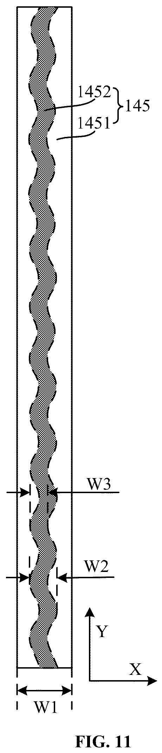

In some embodiments, referring to FIG. 2 or 10, where FIG. 10 is one partial enlarged bottom view of a busbar in a back-contact cell according to one embodiment of the present disclosure, and the orthographic projection of the contact portion 1452 on the cell base 100 may be sawtooth-shaped. In other embodiments, referring to FIG. 3 or 11, where FIG. 11 is another partial enlarged bottom view of a busbar in a back-contact cell according to one embodiment of the present disclosure, and the orthographic projection of the contact portion 1452 on the cell base 100 may be wave-shaped.

It should be noted that both the sawtooth-shaped and wave-shaped orthographic projections are non-linear, with each have a plurality of bends in the second direction Y. The difference between the sawtooth-shaped orthographic projection and the wave-shaped orthographic projection lies in whether the bends are polygonal lines or curved lines. In other words, the difference between the sawtooth-shaped orthographic projection and the wave-shaped orthographic projection lies in the smoothness of the transition at the bends.

Further, the orthographic projection of the plurality of contact portions 1452 on the cell base 100 are designed to be sawtooth-shaped or wave-shaped, compared with the substantially linear same-polarity fingers 167, on the one hand, each contact portion 1452 has a larger cross-sectional area, which is conducive to reducing the internal transport resistance of the contact portion 1452, thereby improving carrier transmission efficiency of the contact portion 1452, shortening the transport distance of charge carriers, and further reducing transport losses of charge carriers. On the other hand, the contact area between the contact portion 1452 and the doped layer 112 is larger, as is the contact are between the contact portion 1452 and the non-contact portion 1451, which is conducive to reducing both the contact resistance between the contact portion 1452 and the doped layer 112, and the contact resistance between the contact portion 1452 and the non-contact portion 1451, thereby shortening a transport distance of charge carriers, and further reducing transport losses of charge carriers from the doped layer 112 to the non-contact portion 1451. In this way, through combined effects of these factors, a transport path of charge carriers at the contact portion 1452 is improved, which further increases the charge carrier collection efficiency of the busbar 145 and enhances the photovoltaic conversion efficiency of the back-contact cell.

In addition, the orthographic projection of the contact portion 1452 on the cell base 100 is designed to be sawtooth-shaped or wave-shaped, compared with the substantially linear same-polarity fingers 167, the risk of mechanical fracture of the contact portion 1452 can be reduced due to a larger cross-sectional area of the contact portion 1452, thus improving the yield of the back-contact cell.

In some embodiments, referring to FIGS. 2, 3, 7, 8, 10, or 11, the orthographic projection of the contact portion 1452 on the cell base 100 may be located within the orthographic projection of the non-contact portion 1451 on the cell base 100.

In some embodiments, referring to FIGS. 4, 5, or 9, in the same busbar 145, the contact portion 1452 and the non-contact portion 1451 are stacked in the third direction Z.

In some embodiments, referring to FIGS. 2 and 10, or FIGS. 3 and 11, in the first direction X, the non-contact portion 1451 has a first width W1, and a layout area occupied by the contact portion 1452 has a second width W2 (i.e., a maximum span of the contact portion 1452 is defined as a second width), where a ratio of the second width W2 to the first width W1 may be 0.2-0.5, for example, 0.25, 0.3, 0.35, 0.4, or 0.45.

It should be noted that, in order to prevent the busbar 145 from occupying excessive width in the first direction X, thereby preventing an opening width at a disconnection of the first finger 106 or the second finger 107 from being too large, and preventing the first finger 106 or the second finger 107 from having a relatively short length in the first direction X, the first width W1 of the non-contact portion 1451 of the busbar 145 is controlled within a predetermined range. On this basis, when the ratio of the second width W2 to the first width W1 is less than 0.2, the second width W2 of the layout area occupied by the contact portion 1452 is too small, which reduces a bending degree of the contact portion 1452, and is conducive to the contact area per unit length between the contact portion 1452 and the doped layer 112 in the second direction Y, which is not conducive to improving the collection capacity of the contact portion 1452 for charge carriers in the doped layer 112. Conversely, when the ratio of the second width W2 to the first width W1 is greater than 0.5, the second width W2 of the contact portion 1452 is too large, which causes an excessively large contact area between the contact portion 1452 and the doped layer 112, easily resulting in significant charge carrier recombination, which is not conducive to reducing charge carrier recombination loss. Therefore, the ratio of the second width W2 to the first width W1 is designed to fall within a range of 0.2-0.5, which helps ensure high collection efficiency of the contact portion 1452 for charge carriers in the doped layer 112, while avoiding large-area contact between the busbar 145 and the doped layer 112, thereby maintaining low charge carrier recombination loss.

In addition, by designing the first width W1 of the non-contact portion 1451 to be larger than the second width W2 of the layout area occupied by the contact portion 1452, the non-contact portion 1451 in the busbar 145 can be configured to further increase an overall cross-sectional area of the busbar 145, thereby reducing the overall transmission resistance of the busbar 145 and improving the electrical conductivity of the busbar 145.

It should be noted that the second width W2 of the layout area occupied by the contact portion 1452 refers to a distance between two bending points that are furthest apart in the first direction X among a plurality of sequentially connected bent segments of the contact portion 1452. In some cases, the second width W2 may correspond to a width of the contact portion 1452 at its widest point in the first direction X.

In some embodiments, referring to FIGS. 2 and 10, or FIGS. 3 and 11, in the first direction X, a width of the layout area occupied by contact portion 1452 is defined as the second width W2, and a width of the contact portion 1452 itself is defined as a third width W3. A ratio of the third width W3 to the second width W2 may be 0.2-0.8, for example, 0.25, 0.3, 0.35, 0.4, 0.45, 0.5, 0.55, 0.6, 0.65, 0.7, or 0.75.

When the ratio of the third width W3 to the second width W2 is less than 0.2, the third width W3 of the contact portion 1452 is too small, which is not conducive to reducing the internal transport resistance of the contact portion 1452, improving the collection efficiency of the contact portion 1452 for charge carriers in the doped layer 112, and reducing the contact resistance between the contact portion 1452 and the doped layer 112. When the ratio of the third width W3 to the second width W2 is greater than 0.8, the third width W3 of the contact portion 1452 is too large, which causes an excessively large contact area between the contact portion 1452 and the doped layer 112, easily resulting in significant charge carrier recombination, which is not conducive to reducing charge carrier recombination loss. Therefore, the ratio of the third width W3 to the second width W2 is designed to fall within a range of 0.2-0.8, which helps ensure high collection efficiency of the contact portion 1452 for charge carriers in the doped layer 112, while avoiding large-area contact between the busbar 145 and the doped layer 112, thereby maintaining low charge carrier recombination loss.

It should be noted that the third width W3 of the contact portion 1452 refers to, in the first direction X, a width of the bent segment in the contact portion 1452, which includes a plurality of sequentially connected bent segments. In some cases, the third width W3 may correspond to a width of the contact portion 1452 at its narrowest point in the first direction X.

A structure of the single contact portion 1452 will be described in detail below.

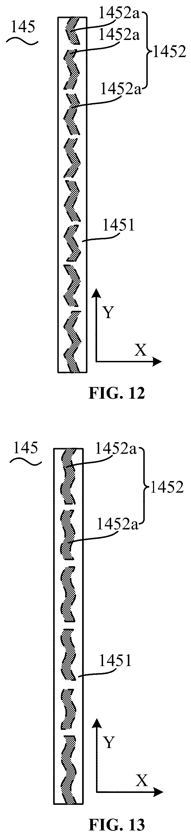

In some embodiments, referring to FIGS. 12-14, a single contact portion 1452 may include a plurality of sub-contact portions 1452a spaced apart in the second direction Y, and each sub-contact portion 1452a extends through the passivation layer 103 and is in contact with the doped layer 112. In this way, a region where a single sub-contact portion 1452a in contact with the doped layer 112 is defined as a single gathering area. A plurality of gathering areas is arranged between the single contact portion 1452 and the doped layer 112, charge carriers in respective regions of the doped layer 112 can be preferentially transported to the non-contact portion 1451 using the sub-contact portion 1452a having a lowest transport resistance, which is conducive to ensuring efficient collection of charge carriers by the busbar 145. Further, a single contact portion 1452 is dispersed into a plurality of sub-contact portions 1452a, which is conducive to dispersing an area where the single contact portion 1452 is in contact with the doped layer 112 into a plurality of gathering areas, thereby effectively reducing an orthographic projection area of each gathering area on the cell base 100, in turn reducing recombination loss of charge carriers in each gathering area, and further reducing recombination loss of charge carriers between the entire contact portion 1452 and the doped layer 112.

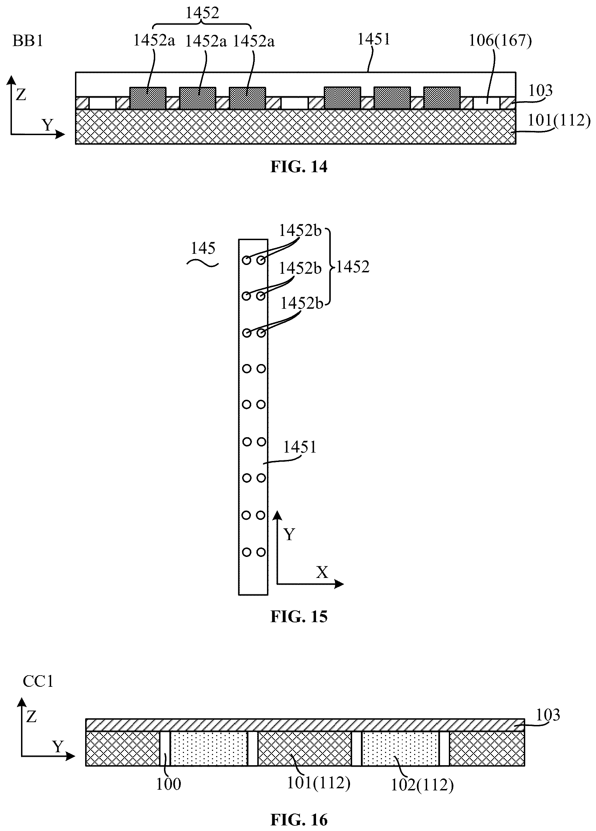

FIG. 12 is one partial bottom view of a busbar of a back-contact cell according to one embodiment of the present disclosure; FIG. 13 is another partial bottom view of a busbar of a back-contact cell according to one embodiment of the present disclosure; and FIG. 14 is another schematic diagram of a partial sectional view of a back-contact cell according to one embodiment of the present disclosure along a second sectional direction BB1.

In some examples, referring to FIG. 12 or 13, the orthographic projection of a single contact portion 1452 on the cell base 100 can be considered to include a plurality of bent segments spaced apart in the second direction Y, with each bent segment being regarded as a single sub-contact portion 1452a. In other examples, the orthographic projection of a single contact portion on the cell base can be regarded as a straight line broken into a plurality of segments, and a sub-contact portion can be regarded as one segment of the straight line.

In other embodiments, referring to FIG. 15, FIG. 15 is yet another partial bottom view of a busbar of a back-contact cell according to one embodiment of the present disclosure; where a single contact portion 1452 may include a plurality of contact points 1452b spaced apart in the first direction X and/or the second direction Y, and each contact point 1452b extends through the passivation layer 103 and is in contact with the doped layer 112. In this way, a region where a single contact point 1452b in contact with the doped layer 112 is defined as a single gathering point. A plurality of gathering points is arranged between the single contact portion 1452 and the doped layer 112, charge carriers in respective regions of the doped layer 112 can be preferentially transported to the non-contact portion 1451 using the contact point 1452b having a lowest transport resistance, which is conducive to ensuring efficient collection of charge carriers by the busbar 145. Further, a single contact portion 1452 is dispersed into a plurality of contact points 1452b, which is conducive to dispersing an area where the single contact portion 1452 is in contact with the doped layer 112 into a plurality of gathering areas, thereby effectively reducing an orthographic projection area of each gathering point on the cell base 100, in turn reducing recombination loss of charge carriers in each gathering point, and further reducing recombination loss of charge carriers between the entire contact portion 1452 and the doped layer 112.

It should be noted that in FIG. 15, a single contact portion 1452 that includes a plurality of contact points 1452b spaced apart in both the first direction X and the second direction Y as an example. In practical applications, the plurality of contact points included in a single contact portion may be spaced apart only in the first direction X, or alternatively, the plurality of contact points included in a single contact portion may be spaced apart only in the second direction Y.

In some embodiments, referring to FIGS. 1-5 and FIGS. 7-15, the orthographic projection area of the non-contact portion 1451 on the cell base 100 is defined as a first area, and the orthographic projection area of the contact portion 1452 on the cell base 100 is defined as a second area. A ratio of the second area to the first area may be in the range of 0.2-0.5, for example, 0.25, 0.3, 0.35, 0.4, or 0.45.

It should be noted that the orthographic projection area of the contact portion 1452 on the cell base 100, that is, the second area, can be regarded as the contact area between the contact portion 1452 and the doped layer 112. When the ratio of the second area to the first area is less than 0.2, the contact area between the contact portion 1452 and the doped layer 112 is too small, which is not conducive to reducing the contact resistance between the contact portion 1452 and the doped layer 112, and is not conducive to improving the collection efficiency of charge carriers in the doped layer 112 by the contact portion 1452. Conversely, when the ratio of the second area to the first area is greater than 0.5, the contact area between the contact portion 1452 and the doped layer 112 is too large, which may lead to significant charge carrier recombination and is not conducive to reducing charge carrier recombination loss. Therefore, the ratio of the second area to the first area is designed to fall within a range of 0.2-0.5, which helps ensure high collection efficiency of the contact portion 1452 for charge carriers in the doped layer 112, while avoiding large-area contact between the busbar 145 and the doped layer 112, thereby maintaining low charge carrier recombination loss.

In some embodiments, referring to FIGS. 4, 9 and 14, with a surface of the cell base 100 as a reference plane, at least some of the contact portions 1452 protrude from a surface of the passivation layer 103.

In some cases, in the third direction Z, a thickness of the passivation layer 103 is on the nanometer scale, while a thickness of the contact portion 1452 is at the micrometer scale, such that the thickness of the contact portion 1452 is greater than that of the passivation layer 103.

In some cases, in the third direction Z, the contact portion 1452 can be divided into two vertically stacked portions, with one portion penetrating the passivation layer 103 and the other embedded in the non-contact portion 1451.

In some embodiments, referring to FIGS. 6, 9 and 14, with a surface of the cell base 100 as a reference plane, a top surface of the same-polarity finger 167 may be flush with the top surface of the passivation layer 103 away from the cell base100. In practical applications, the top surface of the same-polarity finger may also protrude from the top surface of the passivation layer.

In summary, when a back-contact cell generates charge carriers based on the photovoltaic effect, the first fingers 106 are configured to collect charge carriers generated in the first doped portion 101, and the first busbar 104 in contact with the first finger 106 is configured to further gather the charge carriers collected by the first fingers 106; and the second fingers 107 are configured to collect charge carriers generated in the second doped portion 102, and the second busbar 105 in contact with the second fingers 107 are configured to further gather the charge carriers collected by the second fingers 107. On this basis, a gap between two adjacent same-polarity fingers 167, such as between two adjacent first fingers 106, is further provided with a first doped portion 101, and a gap between two adjacent second fingers 107 is further provided with a second doped portion 102. In this way, at least a portion of the busbars 145 are designed to include contact portions 1452 in contact with the doped layer 112 and non-contact portions 1451 not in contact with the doped layer 112. Specifically, at least a portion of the contact portions 1452 of the first busbars 104 is in contact with the first doped portion 101 located in a gap between two adjacent first fingers 106, and/or at least a portion of the contact portions 1452 of the second busbars 105 is in contact with the second doped portion 102 located in a gap between two adjacent second fingers 107, such that charge carriers generated in the doped portions 112 located in a gap between two adjacent same-polarity fingers 167 can be directly collected by the busbars 145 in the third direction Z, thereby shortening a distance of charge carriers transported from the doped portions 112 to the busbars 145. As a result, transport losses of charge carriers are reduced, and the charge carrier collection efficiency of the first busbars 104 and/or second busbars 105 is improved, which contributes to enhancing the photovoltaic conversion efficiency of the back-contact cell.

In addition, in the busbar 145 that include the contact portion 1452, the non-contact portion 1451 does not extend through the passivation layer 103 and is only disposed on a side of the passivation layer 103 away from the cell base 100, such that the non-contact portion 1451 is not in contact with the doped layer 112, and only a portion of the busbar 145 is in contact with the doped layer 112, this will improve the charge carrier collection efficiency of the busbar 145 while avoiding excessive charge carrier recombination caused by large-area contact between the busbar 145 and the doped layer 112, so as to maintain low charge carrier recombination losses.

According to some embodiments of the present disclosure, the present disclosure further provides a fabrication method for a back-contact cell, which is used for fabricating the back-contact cell described in the above embodiments. The fabrication method for a back-contact cell according to another embodiment of the present disclosure will be further described in detail below in conjunction with the accompanying drawings. It should be noted that description identical or corresponding to the previous embodiments are not repeated in detail herein.

Referring to FIGS. 1-4, and FIGS. 16 and 17, the fabrication method for the back-contact cell may include the following operations:

Referring to FIG. 16, FIG. 16 is a schematic diagram of a partial sectional view after forming a first doped portion 101, a second doped portion 102, and a passivation layer 103 in the fabrication method for a back-contact cell according to another embodiment of the present disclosure, where a cell base 100 is provided; the first doped portion 101, and the second doped portion 102 are formed on the cell base 100 at intervals; and a passivation layer 103 is formed, and the passivation layer 103 is disposed on a side of both the first doped portion 101 and the second doped portion 102 away from the cell base 100.

Referring to FIG. 16 and FIGS. 1-4, a first busbar 104 and a second busbar 105 alternately arranged in a first direction X, and first fingers 106 and second fingers 107 alternately arranged in a second direction Y are formed; where the first fingers 106 are designed to be interrupted at the second busbar 105, and the second fingers 107 are designed to be interrupted at the first busbar 104. The first busbar 104 is in contact with the first fingers 106, and their orthographic projections on the cell base 100 are both located within the orthographic projection of the first doped portion 101 on the cell base 100. Similarly, the second busbar 105 is in contact with the second fingers 107, and their orthographic projections on the cell base 100 are both located within an orthographic projection of the second doped portion 102 on the cell base 100. At least a portion of the busbars 145 includes a non-contact portion 1451 and at least one contact portion 1452 in contact with the non-contact portion 1451. The contact portion 1452 extends through the passivation layer 103 and is in contact with a doped layer 112, and a single contact portion 1452 is at least located in a gap between two adjacent same-polarity fingers 167.

Specifically, the busbar 145 serves as the first busbar 104, the doped layer 112 serves as the first doped portion 101, and the same-polarity finger 167 is the first fingers 106, and/or the busbar 145 serves as the second busbar 105, the doped layer 112 serves as the second doped portion 102, and the same-polarity finger 167 serves as the second finger 107.

It should be noted that the non-contact portion 1451 and the contact portion 1452 of the busbar 145 can be prepared and completed in different fabricating steps, thereby achieving a design in which only a portion of the busbar 145 is in contact with the doped layer 112. Further, the contact portion 1452 is formed at least in the gap between two adjacent same-polarity fingers 167, such that charge carriers located in a region of the doped layer 112 farther from the same-polarity fingers 167 can be directly collected via the contact portion 1452, without having to pass through the same-polarity fingers 167 for collection. This configuration is conducive to shortening a distance of charge carriers in the doped layer 112 transported to the busbar 145, thereby reducing carrier transport losses and improving carrier collection efficiency of the busbar 145, and enhancing the photovoltaic conversion efficiency of the back-contact cell. In addition, the entire busbar 145 is prevented from contacting the doped layer 112 to reduce the probability of charge carrier recombination at a connection position between the busbar 145 and the doped layer 112.

Steps for forming the first fingers 106, the second fingers 107, the first busbar 104, and the second busbar 105 will be described in detail below.

In some embodiments, referring to FIGS. 1-4 and 16, the steps for forming the first fingers 106, the second fingers 107, the first busbar 104, and the second busbar 105 may include: printing a burn-through paste on regions of the passivation layer 103 directly opposite the first fingers 106 and the contact portion 1452 of the first busbar 104, and printing a burn-through paste on regions of the passivation layer 103 directly opposite the second fingers 107 and the contact portion 1452 of the second busbar 105; printing a non-burn-through paste on a side of the contact portion 1452 away from the cell base 100 and on a partial top surface of the passivation layer 103; performing a firing process to form the first fingers 106 and the contact portion 1452 of the first busbar 104 that pierce the passivation layer 103 on the first doped portion 101, to form the second fingers 107 and the contact portion 1452 of the second busbar 105 that pierce the passivation layer 103 on the second doped portion 102, and to form the non-contact portion 1451 on the side of the contact portion 1452 away from the cell base 100 and on a portion of the top surface of the passivation layer 103.

It should be noted that the burn-through paste and the non-burn-through paste are printed on the side of the passivation layer 103 away from the cell base, respectively, followed by the firing process, enabling the burn-through paste to fire through the passivation layer 103, then penetrate through the passivation layer 103 and contact the doped layer 112. Specifically, materials for forming the first fingers 106, the contact portion 1452 of the first busbar 104, the second fingers 107, and the contact portion 1452 of the second busbar 105 are all burn-through paste, such that the first fingers 106, the contact portion 1452 of the first busbar 104, the second fingers 107, and the contact portion 1452 of the second busbar 105 are all capable of penetrating through the passivation layer 103 and making contact with the doped layer 112. In this way, the steps of printing the burn-through paste to form the first fingers 106 and the second fingers 107 can be completed simultaneously for forming the contact portion 1452 of the first busbar 104 and the contact portion 1452 of the second busbar 105, therefore, preliminary printing operations of the contact portion 1452 of the busbar 145 can be completed without requiring additional process steps, simplifying the fabricating process of the back-contact cell and improving the fabricating efficiency of the back-contact cell.

In other embodiments, referring to FIGS. 1 and 17, FIG. 17 is a schematic diagram of a partial sectional view illustrating the formation of an opening 113 in the passivation layer 103 according to another embodiment of the fabrication method for the back-contact cell, after the first fingers 106 and the second fingers 107 are formed, steps for forming the first busbar 104 and the second busbar 105 may include: referring to FIG. 17, forming an opening 113 in the passivation layer 103 in a region directly opposite the contact portion 1452, the opening 113 penetrating the passivation layer 103; referring to FIGS. 9 and 17, printing a busbar paste in the opening 113 and on the side of the passivation layer 103 away from the cell base 100; performing a firing process to form the busbar 145 in the opening 113 and on the side of the passivation layer 103 away from the cell base 100, with the contact portion 1452 disposed at least in the opening 113.

It should be noted that forming an opening 113 in the passivation layer 103 to expose a portion of the doped layer 112 in advance helps ensure that the subsequently formed contact portion 1452 can fill the opening 113, achieving contact with the doped layer 112. Specifically, the doped layer 112 exposed by the opening 113 includes at least the doped layer 112 located in the gap between two adjacent same-polarity fingers 167, ensuring that the contact portion 1452 can collect charge carriers from the doped layer 112 located in the gap between two adjacent same-polarity fingers 167.

In some cases, the busbar paste may be a non-burn-through paste. An opening 113 is pre-formed in the passivation layer 103, such that the contact portion 1452 of the busbar 145 located in the opening 113 can be in direct ohmic contact with the doped layer 112. In addition, the busbar 145 formed from the non-burn-through paste does not cause firing damage to a surface of the doped layer 112, thereby further reducing the contact resistance between the contact portion 1452 and the doped layer 112. Moreover, compared with commonly used high-burn-through conductive materials available on the market, low-burn-through conductive materials are more cost-effective, which is conducive to reducing the fabricating cost of the back-contact cell.

In addition, due to the negligible etching or burn-through property of the non-burn-through paste, the thickness of the passivation layer 103 in the third direction Z may be reduced while maintaining the performance of the passivation layer 103. In other words, it is unnecessary to rely on the thickness of the passivation layer 103 to prevent the contact portion 1452 from further penetrating into the doped layer 112 after firing through the passivation layer 103. This is conducive to reducing the thickness of the passivation layer 103, thereby reducing the fabricating cost of the passivation layer 103. It also helps reduce parasitic absorption of light by the passivation layer 103 because of the decrease in the thickness of the passivation layer 103, allowing more light to be absorbed by the cell base 100, thereby further improving the photovoltaic conversion efficiency of the back-contact cell.

In some cases, a laser ablation process may be employed to form the opening 113 in regions of the passivation layer 103 directly opposite the contact portion 1452.

In some embodiments, referring to any of FIGS. 2, 3, 7, 8, 10-15, and FIG. 17, the orthographic projection of the opening 113 on the cell base 100 may coincide with the orthographic projection of the contact portions 1452 ultimately formed on the cell base 100, such that an orthographic projection shape of the opening 113 on the cell base 100 is the same as that of the contact portion 1452 ultimately formed on the cell base 100.

In some embodiments, referring to FIG. 1, the back-contact cell may further include: a plurality of pads (not shown in the figures) disposed on a side of the busbar 145 away from the cell base 100. It should be emphasized that, irrespective of the first busbar 104 or the second busbar 105, a single busbar 145 is provided with a plurality of pads spaced apart in the second direction Y. According to some embodiments of the present disclosure, the present embodiments further provide a photovoltaic module, which is formed by connecting a plurality of back-contact cells according to any of the foregoing embodiments, or by connecting the back-contact cells formed by the fabrication methods according to any of the foregoing embodiments. The photovoltaic module according to yet another embodiment of the present disclosure will be further described in detail below in conjunction with the accompanying drawings. It should be noted that description identical or corresponding to the previous embodiments are not repeated in detail herein.

Referring to FIGS. 1-15, and FIGS. 18 and 19, the photovoltaic module includes: a plurality of cell strings, where a respective cell string of the plurality of cell strings is formed by connecting a plurality of cells, a respective cell of the plurality of cells is the back-contact cell 40 is according to any of the foregoing embodiments, or by connecting a plurality of back-contact cells fabricated using the fabrication method according to any of the foregoing embodiments; at least one encapsulant film 41 configured to cover a surface of the cell string; and at least one cover plate 42 is configured to cover a surface of the at least one encapsulant film 41 away from the cell strings.

FIG. 19 is a partial perspective view of a photovoltaic module according to yet another embodiment of the present disclosure, and FIG. 20 is a schematic diagram of a partial sectional view of the photovoltaic module in FIG. 19 in a fourth cross-sectional direction DD1.

In some embodiments, the back-contact cells 40 are electrically connected as a whole sheet or in a plurality of divided sheets to form a plurality of cell strings, and the plurality of cell strings are electrically connected in series and/or in parallel. The back-contact cell 40 may be either a full-size cell or a singulated cell, where the singulated cell refers to a solar cell formed from a complete full-size cell through a cutting process.

In some embodiments, referring to FIGS. 19 and 20, the plurality of back-contact cells 40 may be electrically connected by a conductive ribbon 43. FIGS. 19 and 20 illustrate only one positional relationship between the back-contact cells 40. In practical applications, the busbars of adjacent back-contact cells may also be disposed on different sides, such that the conductive ribbon is capable of electrically connecting different sides of two adjacent back-contact cells.

In some embodiments, the at least one encapsulant film 41 includes a first encapsulation layer and a second encapsulation layer, where the first encapsulation layer covers one of a front surface or a back surface of the back-contact cell 40, and the second encapsulation layer covers the other of the front surface or the back surface of the back-contact cell 40. Specifically, at least one of the first encapsulation layer or the second encapsulation layer can be an organic encapsulant film, such as a polyvinyl butyral (PVB) film, an ethylene-vinyl acetate (EVA) film, a polyolefin elastomer (POE) film, or a polyethylene terephthalate (PET) film. Alternatively, at least one of the first encapsulation layer or the second encapsulation layer can be an EP film, an EPE film, or a PVP film. The EP film refers to a co-extruded film formed by laminating an EVA film and a POE film. The EPE film refers to a co-extruded film formed by sequentially laminating an EVA film, a POE film, and an EVA film. The PVP film refers to a co-extruded film formed by laminating a POE film, an EVA film, and a POE film. The co-extruded film can be prepared by sequentially extruding one or more raw materials onto another pre-formed film during the film processing, or by adhering different pre-formed films together.

In some cases, the first encapsulation layer and the second encapsulation layer may have a boundary line prior to lamination. After the lamination process, when forming the photovoltaic module, the distinction between the first encapsulation layer and the second encapsulation layer is no longer present, that is, the first encapsulation layer and the second encapsulation layer together form an integrated encapsulant film 41.

In some embodiments, the at least one cover plate 42 may be a glass cover plate, a plastic cover plate, or other light-transmitting cover plate. Specifically, a surface of the at least cover plate 42 facing the at least one encapsulant film 41 may be a textured surface or a velvet-like surface having a plurality of raised structures, thereby increasing the utilization of incident light. The at least one cover plate 42 includes a first cover plate and a second cover plate, where the first cover plate is opposite the first encapsulation layer, and the second cover plate is opposite the second encapsulation layer.

In some cases, when the back-contact cell 40 is a busbar cell, a surface of the back-contact cell 40 is provided with a plurality of busbars spaced apart in a first direction and a plurality of fingers spaced apart in a second direction. In the process of constructing a cell string using the back-contact cells 40, the conductive ribbon 43 is electrically connected to at least one busbar on each back-contact cell 40 of two adjacent back-contact cells 40.

It may be understood by those skilled in the art that the above embodiments are particular embodiments to implement the present disclosure, and in a practical application, various changes can be made to the form and details without departing from the scope of the embodiments of the present disclosure. Those skilled in the art may make variations or modifications without departing from the scope of the embodiments of the present disclosure, therefore, the scope of protection of the embodiments of the present disclosure shall be subject to the scope of protection as defined by the claims.

## Claims

1. A back-contact cell, comprising:
a cell base (100);
a doped layer (112) formed on or in the cell base (100);
a passivation layer (103) formed on a side of the doped layer (112) away from the cell base (100);
first fingers (106) formed over the doped layer (112), extending in a first direction (X) and arranged at intervals in a second direction (Y) intersecting the first direction (X),
the first fingers (106) penetrating the passivation layer (103) to be electrically connected with the doped layer (112);
at least one first busbar (104) formed over the doped layer (112), extending in the second direction (Y), and electrically connected to the first fingers (106);
wherein a respective busbar of the at least one first busbar (104) includes a plurality of contact portions (1452) and a non-contact portion (1451);
the plurality of contact portions (1452) are arranged at intervals in the second direction (Y), and extend through the passivation layer (103) to be in direct contact with the doped layer (112); and
the non-contact portion (1451) extends continuously in the second direction (Y), is located on a side of the plurality of contact portions (1452) away from the cell base (100), and is in direct contact with the plurality of contact portions (1452) and the first fingers (106).

2. The back-contact cell according to claim 1, wherein
a respective contact portion of the plurality of contact portions (1452) is located between two adjacent first fingers (106) in the second direction (Y).

3. The back-contact cell according to claim 1, wherein the plurality of contact portions (1452) and the first fingers (106) satisfy at least one of the following connection relationship:
in direct contact with one of the first fingers (106);
in direct contact with two of the first fingers (106); and
in direct contact with three of the first fingers (106).

4. The back-contact cell according to claim 1, wherein a first portion of the plurality of contact portions (1452) is located between two adjacent first fingers (106) in the second direction (Y), and a second portion of the plurality of contact portions (1452) and the first fingers satisfy at least one of the following connection relationship:
in direct contact with one of the first fingers (106);
in direct contact with two of the first fingers (106); and
in direct contact with three of the first fingers (106).

5. The back-contact cell according to any one of claims 1 to 4, wherein a respective contact portion of the plurality of contact portions (1452) includes a plurality of sub-contact portions (1452a), the plurality of sub-contact portions (1452a) are arranged at intervals along the second direction (Y), and a respective sub-contact portion of the sub-contact portions (1452a) extends through the passivation layer (103) to be electrically connected with the doped layer (112); or
wherein a respective contact portion of the plurality of contact portions (1452) includes a plurality of contact points (1452b), the plurality of contact points (1452b) are arranged at intervals along the first direction (X), or along the second direction (Y), or along both the first direction (X) and the second direction (Y), and a respective contact point of the contact points (1452b) extends through the passivation layer (103) to be electrically connected with the doped layer (112).

6. The back-contact cell according to any one of claims 1 to 5, wherein an orthographic projection area of the non-contact portion (1451) on the cell base (100) is defined as a first area, an orthographic projection area of the plurality of contact portions (1452) on the cell base (100) is defined as a second area, and a ratio of the second area to the first area is in a range of 1:5 to 1:2.

7. The back-contact cell according to any one of claims 1 to 6, wherein an orthographic projection of a respective contact portion of the plurality of contact portions (1452) on the cell base (100) is sawtooth-shaped or wave-shaped;
optionally, wherein in the first direction (X), the non-contact portion (1451) has a first width;
a maximum span of the plurality of contact portions (1452) is defined as a second width;
a ratio of the second width to the first width is in a range of 1:5 to 1:2;
a width of the respective contact portion is defined as a third width; and
a ratio of the third width to the second width is in a range of 1:5 to 4:5.

8. The back-contact cell according to any one of claims 1 to 7, wherein at least some of the plurality of contact portions (1452) protrude from a surface of the passivation layer (103) away from the cell base (100).

9. The back-contact cell according to any one of claims 1 to 8, wherein the plurality of contact portions (1452) are made of a burn-through paste that has been fired to burn through portions of the passivation layer (103) to electrically connect with the doped layer (112), and the non-contact portion (1451) includes a non-burn-through paste formed over the passivation layer (103); or
wherein the plurality of contact portions (1452) fill respective through openings (113) in the passivation layer (103), and the non-contact portion (1451) is formed over the passivation layer (103) outside the at least one opening (113).

10. The back-contact cell according to any one of claims 1 to 9, further comprising:
second fingers (107) formed over the doped layer (112), extending in the first direction (X) and arranged at intervals in the second direction (Y), the second fingers (107) penetrating the passivation layer (103) to be electrically connected with the doped layer (112);
at least one second busbar (105) formed over the doped layer (112), extending in the second direction (Y) intersecting the first direction (X), and electrically connected to the second fingers (107);
wherein the first fingers (106) are interrupted at a position of a respective busbar of the at least one second busbar (105), and the second fingers (107) are interrupted at a position of a busbar of the at least one first busbar (104);
optionally, wherein the cell base (100) has first doped regions and second doped regions arranged alternatingly thereon;
the doped layer (112) includes a first doped portion (101) disposed in the first doped regions and a second doped portion (102) disposed in the second doped regions; and the first fingers (106) extending over the first doped regions and in electrical contact with the first doped portion (101), the second fingers (107) extending over the second doped regions and in electrical contact with the second doped portion (102); an orthographic projection of the at least one first busbar (104) on the cell base (100) and
orthographic projections of the first fingers (106) on the cell base (100) are located within an orthographic projection of the first doped portion (101) on the cell base (100); and
an orthographic projection of the at least one second busbar (105) on the cell base (100) and orthographic projections of the second fingers (107) on the cell base (100) are located within an orthographic projection of the second doped portion (102) on the cell base (100);
optionally, wherein the orthographic projection area of the first doped portion (101) on the cell base (100) is greater than a sum of the orthographic projection areas of the respective first busbar(104) and the first fingers (106) on the cell base (100); and
an orthographic projection area of the second doped portion (102) on the cell base (100) is greater than a sum of the orthographic projection areas of the respective second busbar (105) and the second fingers (107) on the cell base (100).

11. A back-contact cell, comprising:
a cell base (100);
a doped layer (112) formed on or in the cell base (100);
a passivation layer (103) formed on a side of the doped layer (112) away from the cell base (100);
first fingers (106) formed over the doped layer (112), extending in a first direction (X) and arranged at intervals in a second direction (Y) intersecting the first direction (X),
the first fingers (106) penetrating the passivation layer (103) to be electrically connected with the doped layer (112);
at least one first busbar (104) formed over the doped layer (112), extending in the second direction (Y), and electrically connected to the first fingers (106);
wherein a respective busbar of the at least one first busbar includes one contact portion and a non-contact portion (1451);
the one contact portion (1452) extends through the passivation layer (103) to be in direct contact with the doped layer (112); and
the non-contact portion (1451) extends continuously in the second direction (Y), is located on a side of the one contact portion (1452) away from the cell base (100), and
is in direct contact with the one contact portion (1452) and the first fingers (106).

12. The back-contact cell according to claim 11, wherein the one contact portion (1452) is located between two adjacent first fingers (106) in the second direction (Y).

13. The back-contact cell according to claim 11, wherein the one contact portion (1452) and the first fingers (106) satisfy at least one of the following connection relationship:
in direct contact with one of the first fingers (106),
in direct contact with two of the first fingers (106), and
in direct contact with three of the first fingers (106).

14. The back-contact cell according to claim 11, wherein the first portion of the one contact portion (1452) is located between two adjacent first fingers (106) in the second direction (Y), and a second portion of the one contact portion (1452) and the first fingers (106) satisfy at least one of the following connection relationship:
in direct contact with one of the first fingers (106),
in direct contact with two of the first fingers (106), and
in direct contact with three of the first fingers (106).

15. A photovoltaic module, comprising:
a plurality of cell strings, a respective cell string of the plurality of cell strings being formed by connecting a plurality of cells, a respective cell of the plurality of cells being the back-contact cell (40) according to any one of claims 1 to 10;
at least one encapsulant film (41) configured to cover a surface of the respective cell string; and
at least one cover plate (42) configured to cover a surface of the at least one encapsulant film (41) away from the plurality of cell strings.
